# EUROPEAN PATENT APPLICATION

(11) **EP 4 074 672 A1**
(43) Date of publication of application: **19.10.2022**
(21) Application number: 21218406.3
(22) Date of filing: 30.12.2021
(51) Int. Cl.: C04B 35/462, C01G 23/00, C01G 25/00, C01G 45/12, C04B 35/465, C04B 35/468, C04B 35/49, C04B 35/622, C04B 35/624, C04B 35/632, H01L 41/187, H01L 41/318

(54) **METHOD FOR THE PREPARATION OF A LEAD-FREE PIEZOELECTRIC MATERIAL AND PRECURSOR SOLUTION**

(30) Priority: 15.04.2021 IT 202100009503
(71) Applicant: STMicroelectronics S.r.l., 20864 Agrate Brianza (MB) (IT)
(72) Inventor: CASUSCELLI, Valeria, 80128 NAPOLI (IT); SCALDAFERRI, Rossana, 84073 SAPRI (SA) (IT)
(74) Representative: Casciano, Lidia Giulia Rita

(57) **Abstract**

The present invention relates to a method for the preparation of a precursor solution for a ceramic of the BZT-αBXT type wherein X is selected from Ca, Sn, Mn and Nb and α is a molar fraction selected in the range between 0.10 and 0.90 comprising the steps of: a) dissolving at least one barium precursor compound and at least one precursor compound selected from the group consisting of a calcium precursor compound, a tin precursor compound, a manganese precursor compound and a niobium precursor compound in a linear or branched anhydrous alkyl alcohol containing from 2 to 6 carbon atoms and, after dissolution, dehydrating by stripping, to obtain a first solution; b) dissolving at least one zirconium precursor compound and at least one titanium precursor compound in a linear or branched anhydrous alkyl alcohol containing from 2 to 6 carbon atoms in the presence of an anhydrous chelating agent to obtain a second solution; c) joining said first and second solutions in an anhydrous environment and dehydrating by stripping to obtain said precursor solution. It also relates to a precursor solution, to a method for the preparation of a film of a piezoelectric material, to a piezoelectric material and to an electronic device comprising this piezoelectric material.

## Description

The present invention relates to a new procedure for the preparation of a lead-free piezoelectric material.

Piezoelectric materials are materials that are able to expand or contract when a voltage is applied (electrostrain effect) and conversely to generate a voltage if they are subject to pressure (piezoelectric effect).

They are therefore a very important class of materials that are able to convert mechanical energy into electrical energy and vice versa. They have been, in fact, widely used in products in the field of energy conversion, such as actuators and sensors, and are widespread in common applications but also in cutting-edge technologies, performing a fundamental role in today's society.

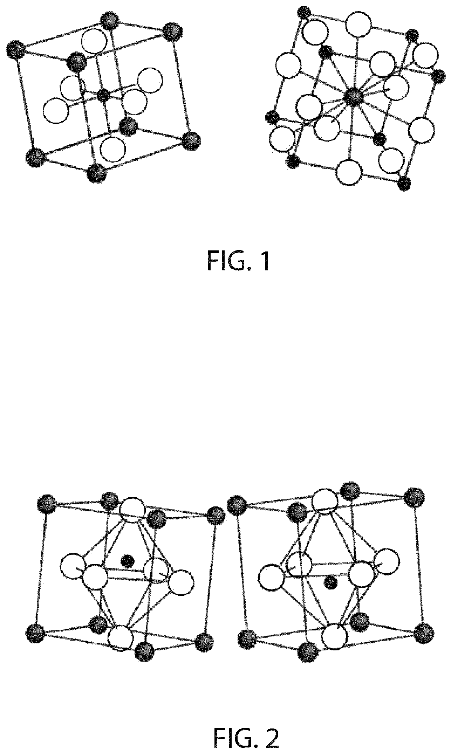

Piezoelectric materials have a crystalline structure of the perovskite type. Mineral perovskite is a calcium titanate, having the chemical formula CaTiO₃. The family of perovskite oxides has a generic composition ABO₃, where the element A (in grey in Figures 1A and 1B) is 12-fold coordinated with respect to oxygen (in white in Figures 1A and 1B) and the element B (in black in Figures 1A and 1B) presents octahedral coordination with oxygen. The site A is positioned at the corner of a cube, the site B is at the center, and an oxygen is positioned at the center of each face. Alternatively, the structure might be represented with the site B at the corner of the cube, the site A at the center and the oxygen atoms at the midpoint of each edge (Figures 1A and 1B, respectively).

The perovskite-type structure shows excellent tolerance to variations in its composition and to possible distortions of the final material owing to its capacity to adapt to a misalignment in the balance between the lengths of the AO and BO bonds, thus enabling the existence of a large number and variety of stoichiometric compounds.

The distortions, for example tetragonal (Figure 2), orthorhombic, rhombohedral, and monoclinic distortions, in fact give rise to changes in the symmetry of the crystal, where one or more cations displace from positions with high symmetry in the lattice, this resulting in a ferroelectric or anti-ferroelectric behavior. In other words, a spontaneous polarization is caused when the center of the positive charge and the center of the negative charge within the unitary cell do not coincide.

However, in a ferroelectric material the spontaneous polarization is necessary but not sufficient, since the reorientation of polarization by an electrical field is required.

The most widespread family of piezoelectric materials is certainly that of lead-zirconate-titanate (PZT) ceramics, owing to the high values of the piezoelectric coefficient, of the dielectric constants, and of the coupling factors. These properties have been observed in compositions in the proximity of a morphotropic-phase boundary (MPB). The MPB presents a slight dependence upon temperature so that the stability of the properties is reached over a wide temperature range.

However, since PZT contains a large amount of toxic lead, the use of these materials is subject to stringent standards for environmental reasons.

In the last few years, therefore, various lead-free systems have been investigated, amongst which barium titanate, titanates of bismuth and an alkaline metal, and niobates.

Wenfeng Liu et al. in "Large Piezoelectric Effect in Pb-free Ceramics", Phys. Rev. Letters, (2009), 103, 257602, and in US20110037015 studied the ceramic (1-α)Ba(Zr_{0.2}Ti_{0.8})O₃-α(Ba_{0.7}Ca_{0.3})TiO₃ (BZT-αBCT), where α is a molar fraction comprised between 0 and 1, obtained using a conventional solid-state reaction method.

They reported that the existence of a cubic-rhombohedral-tetragonal (C-R-T) triple point in the phase diagram located at x=0.32 and T=57°C resulted in materials with high piezoelectricity, with values comparable to those of piezoelectric transducers made of lead-zirconate titanate (PZT) with high sensitivity or high polarization. In particular, the authors showed that ceramics having a perovskite structure and a complex composition of the 0.5Ba(Ti_{0.8}Zr_{0.2})O₃-0.5(Ba_{0.7}Ca_{0.3})TiO₃ (BZT-0.5BCT) type have a high piezoelectric coefficient d₃₃ of up to 620 pC/N at a relatively low Curie temperature (Tc~93°C), whereas BZT-BCT composite ceramics showed a higher Tc~114°C for x=0.53.

Single-crystal BZT-BCT composites at the morphotropic-phase boundary (MPB) have shown a high piezoelectric coefficient d₃₃∼1500-2000 pC/N. By optimizing the poling conditions for ceramic composites of the Ba(Ti_{0.8}Zr_{0.2})O₃-0.5(Ba_{0.7}Ca_{0.3})TiO₃ type, a high piezoelectric coefficient of d₃₃~ 630 pC/N has been observed, with a planar electromechanical factor of 56%.

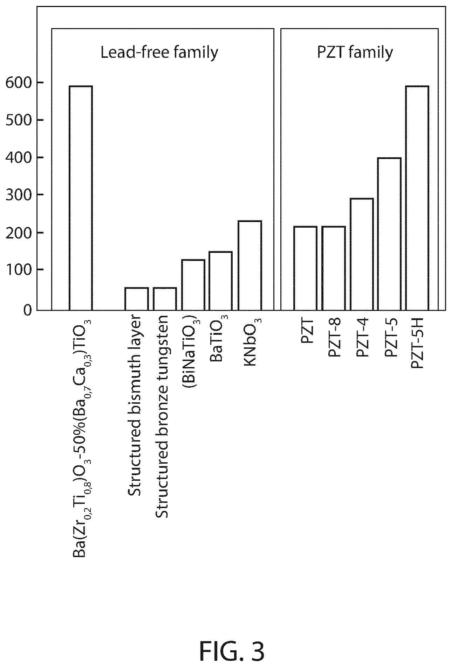

Figure 3 presents a comparison between the piezoelectric coefficient d₃₃ of a BZT-0.5BCT material, those of other lead-free piezoelectric materials, and those of the materials of the PZT family. As emerges clearly from Figure 3, not only do lead-free BZT-BCT materials have piezoelectric coefficients at least twice higher than those of other lead-free piezoelectric materials, but moreover these properties are better than those of the majority of PZT materials.

However, the technique of preparing lead-free BZT-BCT materials by conventional solid-state reaction is quite complex and not easily integrable with the standard semiconductor manufacturing technology. There have thus been developed techniques that are simpler, less costly and that enabled a better control of the stoichiometry of the final compound, for example sol-gel techniques.

Using the sol-gel technique, Xianghua Liu et al., in "Preparation and Characterization of (Ba0.88Ca0.12)(Zr0.12Ti0.88)O3 Powders and Ceramics Produced by Sol-Gel Process", Advanced Materials Research (2010), 148-149, 1062-1066, prepared lead-free BZT-BCT ceramics, with a maximum piezoelectric coefficient d₃₃~400 pC/N. A system with a slight variation in the composition of (Ba_{0.88}Ca_{0.12})(Zr_{0.12}Ti_{0.88})O₃ was moreover prepared, the piezoelectric coefficient d₃₃ of which drastically dropped to 215 pC/N.

The sol-gel technique consists in mixing metal-organic compounds (principally metal alkoxides) in an organic solvent. The subsequent addition of water generates two reactions: one of hydrolysis, and one of condensation.

M(OR)n + xH₂O → M(OH)ₓ(OR)ₙ₋ₓ + xROH (hydrolysis)

M-OR + MOH → M-O-M + R-OH

or

M-OH + M-OH → M-O-M + H-OH (condensation)

These reactions lead to the formation of a three-dimensional lattice of particles.

The sol precursor may then be dried and calcined to obtain a crystalline ceramic or alternatively may be stabilized via a fine control of the competitive reactions, and the reagents may be used for producing thin films

The majority of thin films of ferroelectric ceramics may be deposited on silicon substrates coated with platinum, of the Pt(111)/Ti/SiO₂/Si(100) type, with a composition close to the morphotropic phase boundaries using various deposition methods: sputtering pulsed laser ablation, screen-printing, metal-organic chemical vapor deposition, methods of sol-gel deposition and chemical solution deposition (CSD).

Chemical solution deposition (CSD), in particular of solutions obtained using the sol-gel technique, affords some advantages on account of the low temperatures that may be used, the homogeneity of composition, the possibility of covering extensive surface areas of the substrate, and the simplicity of the process as compared to other methods, such as physical-deposition methods.

In the literature, various sol-gel syntheses of BZT-BCT have been proposed that use the following reagents.

| **Ba source** | **Ca source** | **Ti source** | **Zr source** | **Solvent / Chelanting agent** | **El./piezoel. characteristics** |
|---|---|---|---|---|---|
| Met. Ba | Ca(NO₃)₂ | TiIP | ZrIP | 2-MOE | ε:~3000 tanδ: 0.06 |
| | | | | | Pᵣ: 15.8 µC/cm² |
| | | | | | E_{c}: 58 kV/cm |
| | | | | | d33: 71.7 pm/V |
| BaAc | CaAc | TiBut | ZrON | ETOH/H₂0 HAc | Pᵣ: 22.15 mC/cm |
| | | | | | E_{c}: 68.06 kV/cm |
| BaAc | Ca-Ac | TiIP | Zrn-P | 2-MOE HAc | ε: 457 |
| | | | | | tanδ:0.031 |
| | | | | | Dₘₐₓ :0.86 nm |
| | | | | | J :~6 × 10⁻⁵ A/ cm |
| | | | | | P :141 µC/ m² K |
| | | | | | F_{d}: 0.50 × 10⁻⁵ Pa^{-1/2} |
| BaAc | Ca-Ac | TiIP | Zrn-P | 2-MOE HAc | d33 : 113.6 pm/V |

| | | | | | |
|---|---|---|---|---|---|
| (BaAc= barium acetate; CaAc= calcium acetate; TiIP= titanium isopropoxide; ZrIP= zirconium isopropoxide; ZrON= zirconium oxynitrate; ZrAcAc = zirconium acetylacetate; TiBut= titanium butoxide; Zrn-P= zirconium n-propoxide; HAc= acetic acid; 2-MOE= 2-methoxy ethanol; ETOH= ethanol; AcAc= acetylacetone) | | | | | |

As may be noted, the most used sol-gel systems are those that use 2-methoxyethanol (2-MOE) as solvent. However, 2-methoxyethanol is highly toxic for humans.

Furthermore, the systems that do not make use of 2-MOE lead to the formation of unstable sol solutions that gel in a short time, rendering difficult storage of the solution and its subsequent use in the deposition of thin piezoelectric films.

It has also been observed that the precursor solution used for the preparation of thin films of BZT-BCT ceramics not only does affect the morphology of the film in terms of homogeneity of the microstructure but also the crystallization of the structure. In fact, the homogeneity of the precursor solution allows a fine compositional control and a lower crystallization temperature to be obtained avoiding the presence of segregated phases.

The methods of the prior art do not consider the crucial aspect of the homogeneity of the precursor solution in the preparation of BZT-BCT thin films. In fact, the optimization of a thin film production line by spin coating is linked to the physicochemical properties of the precursor solution and depends on the choice of the suitable temperature to obtain the formation of the amorphous gel, the pyrolysis of the organic matter and the crystallization.

It is therefore desired to lower the crystallization temperature of the precursor solution to obtain well crystallized dense films by improving the homogeneity of the solution. Furthermore, in certain conditions, a high temperature of the annealing step may negatively affect the electrical properties of the thin film.

Therefore, it is desirable to improve the sol-gel method for the synthesis of piezoelectric materials which does not make use of solvents which are carcinogenic and mutagenic for humans and toxic for the environment and which leads to the formation of sol solutions which are stable over time and which allow to obtain thin films being homogeneous and having improved ferroelectric properties.

The aim of the present invention is therefore to provide a new method for the preparation of a precursor solution for the synthesis of piezoelectric materials of the BZT-BCT type that does not make use of solvents which are carcinogenic and mutagenic for humans and toxic for the environment and which allows to obtain a homogeneous precursor solution and the preparation of thin films with improved ferroelectric properties.

This aim is achieved by the present invention, as it relates to a method for the preparation of a precursor solution according to claim 1, to a precursor solution according to claim 11, to a method for the preparation of a film of a piezoelectric material according to claim 12, to a piezoelectric material according to claim 13 and to a device according to claim 15.

The present invention will now be described in detail with reference to the annexed drawings, wherein:
- Figure 1 illustrates the unit of the cell of an ideal cubic perovskite of the ABO₃ type;
- Figure 2 illustrates the tetragonal ferroelectric distortion of the perovskite structure in the two polarization states;

- Figure 3 illustrates the piezoelectric properties d₃₃ of piezoelectric materials in MPB composition;
- Figure 4 shows a block diagram of an electronic apparatus including a device having a piezoelectric region;
- Figures 5A and 5B are respectively a top view and a cross-section view of an operating region of the device of Figure 4, according to an embodiment;
- Figures 6A and 6B are respectively a top view and a cross-section view of an operating region of the device of Figure 4, according to a different embodiment;
- Figure 7 illustrates the diffraction pattern of the powders dried at 120°C of the solution prepared according to standard methods present in the literature (7A) and the diffraction pattern of the powders dried at 120°C of the solution prepared according to the present invention (7B);
- Figure 8 illustrates the thermogravimetric analysis for a solution prepared by the method of the present invention;
- Figure 9 illustrates a typical ferroelectric hysteresis curve (P-E) wherein the Residual Polarization is indicated with Pr and the coercive field with Ec;
- Figure 10 illustrates the P-E curves measured at a frequency of 5kHz for a device according to Figure 6 (10A) and according to Figure 5 (10B);
- Figure 11 illustrates the comparison between the curves of capacitance as the frequency varies measured for a device according to Figure 5 and according to Figure 6;
- Figure 12 illustrates the comparison between the diffraction spectra of the BNZT-BCNT and BZT-BCT tablets;
- Figure 13 is a cross-section of a test structure for the evaluation of the electrical characteristics of BNZT-BCNT and BZT-BCT tablets; and
- Figure 14 illustrates the comparison of the ferroelectric curves measured at the frequency of 1kHz for a BNZT-BCNT and BZT-BCT disc.

According to the present description, a method is provided for the preparation of a precursor solution for a ceramic of the BZT-αBXT type wherein X is selected from Ca, Sn, Mn and Nb and α is a molar fraction selected in the range between 0.10 and 0.90 comprising the steps of:
a) dissolving at least one barium precursor compound and at least one precursor compound selected from the group consisting of a calcium precursor compound, a tin precursor compound, a manganese precursor compound and a niobium precursor compound in a linear or branched anhydrous alkyl alcohol containing from 2 to 6 carbon atoms and, after dissolution, dehydrating by stripping, to obtain a first solution;
b) dissolving at least one zirconium precursor compound and at least one titanium precursor compound in a linear or branched anhydrous alkyl alcohol containing from 2 to 6 carbon atoms in the presence of an anhydrous chelating agent to obtain a second solution;
c) joining said first and said second solutions in an anhydrous environment and dehydrating by stripping to obtain said precursor solution.

By the term "precursor solution" is understood a mixture containing all the necessary components used to form a BZT-BXT ceramic following a suitable treatment.

Advantageously, the method described above allows the preparation of a substantially water-free and homogeneous precursor solution. The precursor solution obtained with the described method allows the crystallization temperature to be reduced and a dense and well crystallized thin film to be obtained with a consequent improvement of its electrical properties in terms of resistance, dielectric and ferroelectric properties both in planar and vertical configuration.

In particular, step a) and step c) are carried out in a rotary evaporator.

In one embodiment, step b) is further carried out in the presence of at least one niobium or tungsten precursor compound.

The addition of niobium or tungsten in the preparation of the precursor solution allows to obtain doped BZT-BCT ceramics that have higher piezoelectric coefficients, dielectric losses and dielectric constants in the face of a reduction in the coercive field.

### Metal compounds

In the present text, by "barium precursor compound", "calcium precursor compound", "tin precursor compound", "manganese precursor compound", "niobium precursor compound", "zirconium precursor compound", "titanium precursor compound" and "tungsten precursor compound" are understood compounds wherein an organic group is bonded, respectively, to the metal element Ba, Ca, Sn, Mn, Nb, and Zr, Ti and W through an oxygen or nitrogen atom of the organic group. The choice of the metal precursors determines the nature of the cations of the sites A and B of the perovskite structure.

In particular, the precursor compounds of Ca, Ba, Zr, Ti, Sn, Nb, Mn and W may be chosen in the group consisting of metal alkoxides, metal-diol complexes, metal-thiol complexes, metal carboxylates, metal-3-diketonate complexes, metal-3-diketoester complexes, metal-3-iminoketo complexes, metal-amine complexes, more in particular, metal alkoxides, their partial hydrolysates and metal carboxylates.

Examples of a precursor compound of Ca include acetates, such as calcium acetate (Ca(OAc)₂).

Examples of a precursor compound of Ba include acetates, such as barium acetate (Ba(OAc)₂).

Examples of a precursor compound of Ti comprise alkoxides, such as titanium tetraethoxide (Ti(OEt)₄), titanium tetraisopropoxide (Ti(OiPr)₄), titanium tetra-n-butoxide (Ti(OnBu)₄), titanium tetraisobutoxide (Ti(OiBu)₄), titanium tetra-t-butoxide (Ti(OtBu)₄), or titanium dimethoxy diisopropoxide (Ti(OMe)₂(OiPr)₂), more in particular titanium tetrabutoxide and titanium isopropoxide.

Examples of precursor compounds of Zr are zirconium n-propoxide, zirconium tetraethoxide (Zr(OEt)₄), zirconium tetraisopropoxide (Zr(OiPr)₄), zirconium tetra-n-butoxide (Zr(OnBu)₄), zirconium tetraisobutoxide (Zr(OiBu)₄), zirconium tetra-t-butoxide (Zr(OtBu)₄), or zirconium dimethoxy diisopropoxide (Zr(OMe)₂(OiPr)₂), more in particular zirconium n-propoxide. Examples of a precursor compound of Mn include manganese acetate.

Furthermore, examples of precursor compounds of Nb include niobium alkoxides, in particular niobium pentaethoxide.

Examples of precursor compounds of W include tungsten alkoxides, in particular tungsten pentaethoxide and 1,2-dimethoxyethane tungsten ethoxide.

Among the precursor compounds of Ti and Zr particularly indicated are the alkoxides that are favored on account of their high reactivity and capacity of forming the desired phases at low reaction temperatures, whereas among the compounds of Ba and Ca carboxylates are favored.

### Solvent

The choice of the solvent is linked to the desire to identify a means in which the compounds of Ba, Ca, Sn, Mn, Nb, Zr, Ti and W are mutually compatible, but above all to obtain a clear and stable sol solution.

It has been found that the presence of residual water deriving from hydration of the metal compounds, from environmental humidity, or from residue in the solvents leads to precipitation of the gel in the sol solution, thus determining the instability of the same. Furthermore, the presence of both hygroscopic and structural water substantially reduces the homogeneity of the precursor solution.

It is therefore desired to remove the presence of residual water during the preparation of the gel solution.

This result is achieved due to the use of anhydrous solvents and the dehydration of organic salts.

It has been observed that the use of a linear or branched anhydrous alkyl alcohol containing from 2 to 6 carbon atoms, preferably selected from the group consisting of ethanol, 1-butanol, 1-propanol, 2-propanol, 2-butanol, isobutyl alcohol, 1-pentanol, 2-pentanol and 2-methyl-2-pentanol, allows sol solutions to be obtained that remain clear and stable over time.

### Chelating Agent

To stabilize the metal compounds upon decomposition, in particular the titanium and zirconium compounds, chelating agents are to be used.

The chelating agents act both by physically surrounding the cation in solution (steric hindrance) and by binding directly thereto in order to reduce its chemical reactivity (inductive effect).

Examples of anhydrous chelating agents are acetylacetone (2,2-pentanedione, or AcAc), glacial acetic acid (HAc), glycerol, propylene glycol, anhydrous ethylene glycol, diethanolamine, EDTA (ethylenediaminetetraacetic acid), triethanolamine, preferably glacial acetic acid and anhydrous ethylene glycol.

Acetic acid (HAc) may be used for reducing the reactivity of titanium alkoxides. Gelling and precipitation in sols containing titanium alkoxides may be suppressed with the addition of moderate amounts of acetic acid.

According to the present disclosure, a precursor solution is also provided for a ceramic of the BZT-αBXT type, where X is selected from Ca, Sn, Mn, and Nb, and α is a molar fraction selected in the range between 0.10 and 0.90 obtained according to the method described above.

Furthermore, according to the present disclosure, a piezoelectric material is made of a ceramic of the BZT-αBXT type where X is selected from Ca, Sn, Mn, and Nb, and α is a molar fraction selected in the range between 0.10 and 0.90 obtained from the precursor solution obtained with the method described above. This material is preferable in the form of film or powder.

This material may be used instead of conventional PZTs, for example in applications such as sensors for airbags, fuel piezo-injectors, ignition sources for gas lighters, detonation sensors, angle sensors for motor vehicles, hard disks, ink-jet print heads, touch sensors for PC monitors, atomization sources for humidifiers and inhalers, smoke detectors, devices for cleaning jewelry and contact lenses, accelerometers, pollution detectors, flow meters, detectors of air bubbles in tubes, impact sensors, level indicators, micropositioning equipment, pressure sensors, nondestructive ultrasound cleaning devices, ultrasound degreasers, ultrasound grinders, welders, ultrasound apparatuses, dental appliances, nebulizers, ultrasound therapy, sonars, orientation systems, optical and acoustic microphones, speakers, tweeters, resonators, filters, microactuators for scanning electron microscopes and cameras, non-volatile memories.

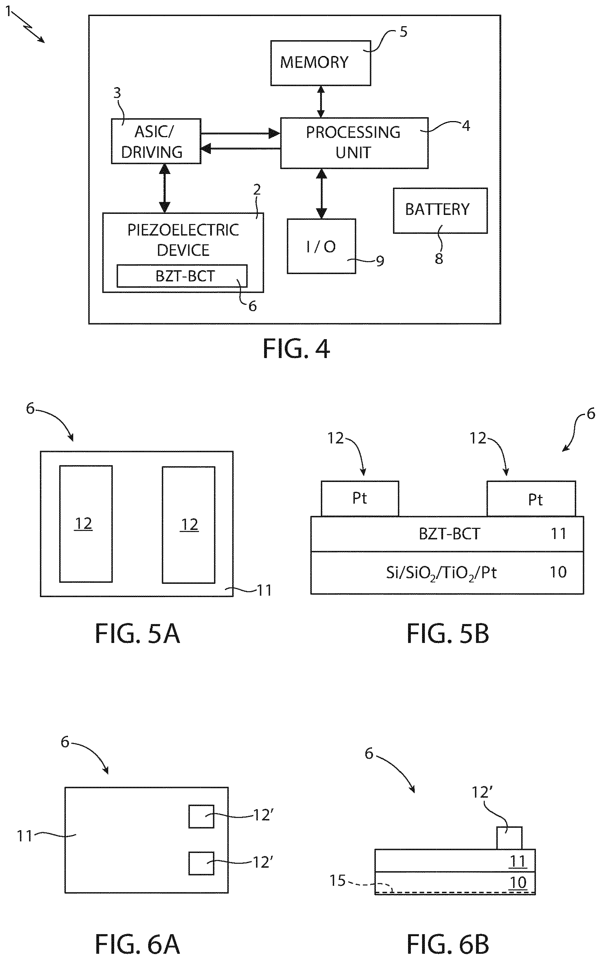

Figure 4 schematically shows an electronic apparatus 1 which uses a device 2 including an operating region 6 including the piezoelectric material discussed above.

The electronic apparatus 1 comprises, in addition to the device 2, a signal conditioning circuit 3, for example an ASIC ("Application Specific Integrated Circuit") connected to the device 2; a processing unit 4, for example a microprocessor, connected to the ASIC 5; a memory 5, connected to the processing unit 4; a battery 8 for supplying the various blocks of the electronic apparatus 1; and an input/output interface 9, which is also connected to the processing unit 4.

The device 2 may be a MEMS sensor; in this case the operating region 6 is a sensitive region including a layer consisting of the piezoelectric material discussed above. The sensitive region may be suspended, for example formed by a membrane or may be clamped (so-called "clamped" region); in both cases, the sensitive region 6 is configured to deform upon detection of an external physical quantity.

The ASIC 3 is electrically coupled to the device 2 so as to receive the electrical sensing signals generated by the latter and supply processed signals to the processing unit 4. The processing unit 4 receives the processed signals and supplies to the outside world the values of the detected physical quantities and/or information correlated thereto. Alternatively, the device 2 may be a MEMS actuator, instead of a MEMS sensor. In this case, the operating region 6 forms an actuation region and the device 2 is connected to a driving unit (again indicated with 3). The driving unit 3 generates electrical signals for driving the device 2 on the basis of command signals received by the processing unit 4, to suitably polarize the operating region 6 and cause the actuation deformation thereof, in a per se known manner.

In both cases, the operating region 6 may have electrodes arranged in a planar or vertical manner.

For example, in Figures 5A and 5B an operating region 6 having electrodes with planar structure is shown.

In detail, the operating region 6 of Figures 5A and 5B has a support 10; a piezoelectric region 11 and electrodes 12.

The support 10 is here formed by a stack of layers of silicon/silicon oxide/titanium oxide/platinum (Si/SiO₂/TiO₂/Pt). The support 10 has a thickness linked to the intended application, for example equal to 100 nm; the silicon layer may be in contact with the piezoelectric region 11 and the platinum layer may be arranged facing outwards, to allow the electrical connection, if desired.

The piezoelectric region 10 is formed by a layer of ceramic of the BZT-αBXT type, where X is selected from Ca, Sn, Mn and Nb and α is a molar fraction selected in the range between 0.10 and 0.90 obtained from the precursor solution obtained with the method described above. The piezoelectric region 10 may have a thickness linked to the specific application and comprised between 100nm and 10um, for example of 500nm.

The electrodes 12 are made for example of platinum (Pt) and are used for the polarization of the piezoelectric region 10, that is the detection of electrical signals. The electrodes 12 may have a thickness of, for example, 100 nm; they may have a rectangular shape, as visible in the top view of Figure 5A, with a short side of 1.1 mm and a long side of 2 mm; and they may be arranged at a distance linked to the application, for example of 100 µm.

Figures 6A and 6B show an operating region 6 having electrodes with a vertical structure.

In detail, the operating region 6 of Figures 5A and 5B also comprises a support 10; a piezoelectric region 11 and at least one top electrode 12'; the support 10, the piezoelectric region 11 and the at least one top electrode 12' are made of the same materials as the structures of the same name described above for Figures 5a, 5B.

In Figure 6B, the platinum layer (indicated with 15), which is a bottom electrode, has been represented dashed in the support 10; Figure 6A shows two top electrodes 12'. The at least one top electrode 12' may have a square shape in top view, with a side of, for example, 0.5 mm; however, the number, arrangement and spacing of the top electrodes 12' may vary according to the application and design considerations.

The operating region 6 is then polarized by applying a suitable voltage to the electrodes 12', 15, that is the electrodes 12', 15 are used for detecting electrical signals indicative of the strains and deformations of the piezoelectric region 11.

According to the present disclosure, there is also provided a method for the preparation of a film of a piezoelectric material made of a ceramic of the BZT-αBXT type, where X is selected from Ca, Sn, Mn, and Nb, and α is a molar fraction selected in the range between 0.10 and 0.90, comprising a step of depositing on a substrate the precursor solution described above, a calcining step, and a sintering step.

In particular, the precursor solution may be applied by spin-coating on a suitable substrate, for example a silicon substrate coated with platinum. Next, the solution is calcined and sintered (annealing) at high temperatures in the presence of oxygen to obtain a homogeneous crystalline film.

In particular, the calcining step may be conducted at a temperature comprised between 300°C and 450°C, and the sintering step at a temperature of 550-730°C. This allows thin films to be obtained that are dense and without cracks. This cycle of deposition, calcining, and sintering may be repeated a number of times to obtain films of different thicknesses stacked on one another.

Possibly, prior to the calcining step, a drying step may be carried out to remove the solvent, in particular at a temperature comprised between 100°C and 200°C.

Where it is instead necessary to obtain a piezoelectric material in the form of powder, the precursor solution is first calcined at a temperature comprised between 300°C and 450°C, and subsequently sintered at a temperature of 700-1200°C.

Further characteristics will emerge from the ensuing description of some merely illustrative and non-limiting examples.

### Example 1

### BZT-BCT - Preparation and Characterization

The salts of barium and calcium, barium acetate and calcium acetate monohydrate are dissolved in 50 ml of butanol in a 1-liter glass flask connected to a rotary evaporator by setting an oil bath temperature of 85°C for about 1h. Then the oil bath temperature is raised to 125°C to completely dehydrate the salts.

At the same time, in a nitrogen atmosphere the titanium butoxide and zirconium butoxide with suitable stoichiometric concentrations are stabilized: in detail, the titanium butoxide is dissolved in 10 ml of acetic acid and stirred and after 15 minutes the zirconium butoxide is also added and about 1 h is awaited for the complete stabilization.

Once the alkoxides have been stabilized, 50 ml of anhydrous butanol and 10 ml of glacial acetic acid are added. This solution is added to the dehydrated salts in the evaporator with 10 ml of anhydrous ethylene glycol, inside the flask to dissolve the dehydrated salts. The volume of any lost solvent is added to achieve the desired molarity. A precursor solution is thus obtained.

The powder obtained by drying the precursor solution prepared by a rotary evaporator is amorphous compared to the powder obtained with the precursor solution prepared with the standard procedure reported in IT 102015000078953.

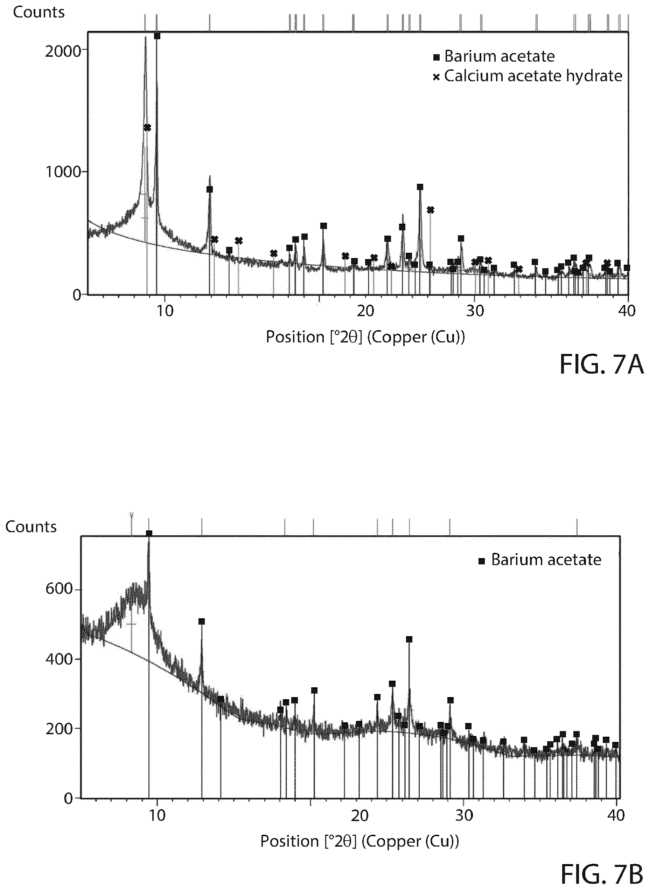

Figures 7A and 7B respectively show the diffraction pattern of the powders dried at 120°C of the solution prepared according to the method illustrated in IT 102015000078953 (7A), and the diffraction pattern of the powders dried at 120°C of the solution prepared according to the present invention (7B).

Figure 7A highlights a wealth of peaks due to the presence of multiple crystalline structures: from the comparison with the crystallographic databases, the structures of barium acetate and hydrated calcium acetate may be identified.

Figure 7B highlights how the represented pattern is more amorphous than the previous one; however, minor peaks remain due to the presence of barium acetate.

The thermal behaviors of the powders of the precursor solution were analyzed by differential thermal analysis (DTA) and differential thermogravimetric analysis (DTG) in nitrogen. The temperature was acquired from an environmental temperature of 1200°C at a heating rate of 10°C/min.

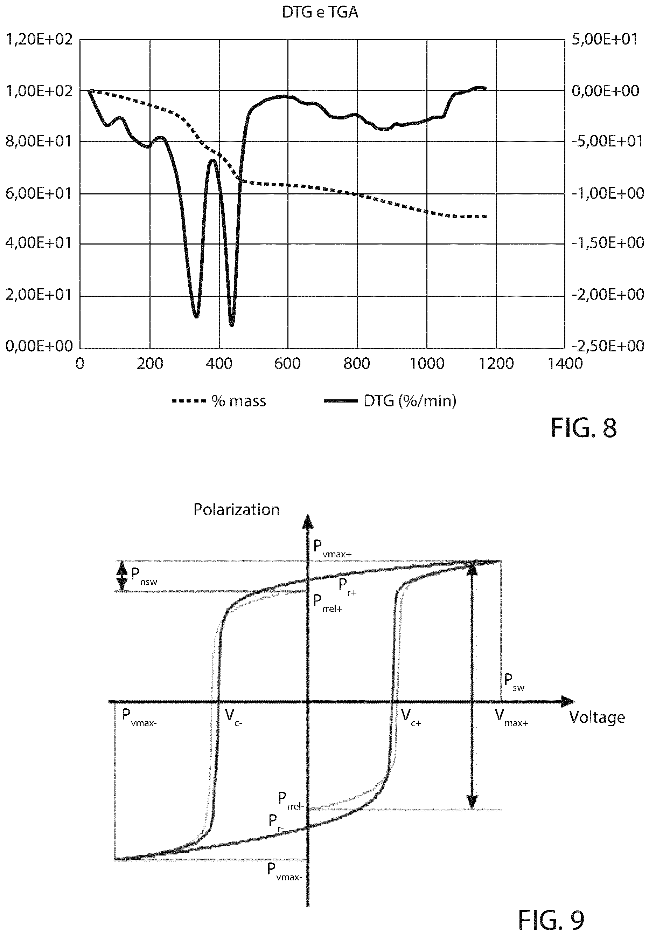

The TGA-DTG curve (Figure 8) reveals the main thermal events related to the mass variation for a sample of dried powders from a solution prepared by the present invention as a function of the temperature, due to evaporation of the residual solvent, pyrolysis of the organic material and decomposition of the carbonates with simultaneous crystallization of BZT-BCT.

The ferroelectric properties of a thin film made with the method described above, both in planar and vertical configuration (Figures 5A-5B and 6A-6B), were observed with an Aixact TFA2000 by measuring the polarization as a function of the electric field curve.

The results are reported in Table 1.

**Table 1**

| Tested device | Freq. [kHz] | ΔEc [kV/cm] | ΔPr [uC/cm²] |
|---|---|---|---|
| Vertical | 5 | 20.6 | 0.5 |
| Planar | 5 | 1.2 | 1650 |
| Vertical | 1 | 43.0 | 1.2 |
| Planar | 1 | 5 | 2553 |

Figure 9 shows a typical ferroelectric hysteresis curve (P-E) wherein the points corresponding to the Residual Polarization are indicated with Pr and -Pr and those corresponding to the coercive field with Ec and -Ec.

The values of ΔPr and ΔEc reported in Table 1 were obtained from the measured experimental ferroelectric curves.

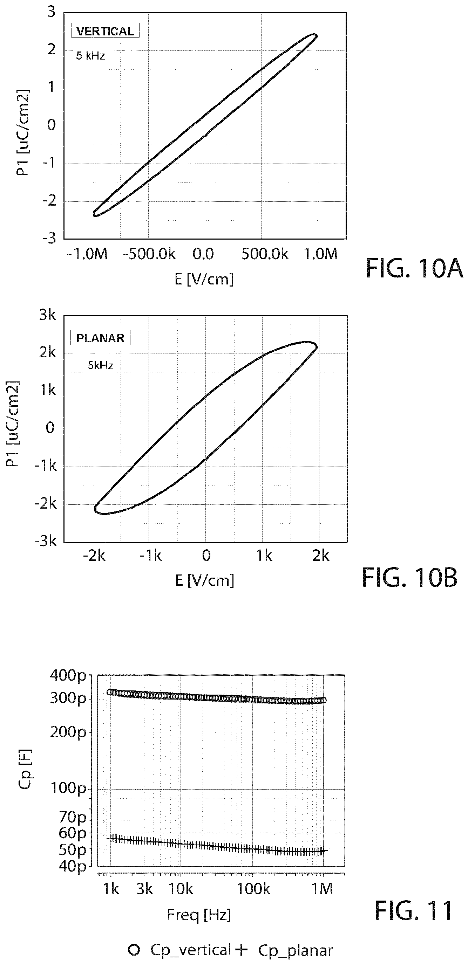

Figures 10A and 10B show the ferroelectric curves measured at the frequency of 5kHz for a vertical device and for a planar device, respectively.

### Comparison with the Precursor Solutions of IT 102015000078953

Due to the formation of cracks, it was not possible to test the materials of the prior art (IT 102015000078953) with electric fields greater than 600kV/cm. On the contrary, the thin films obtained according to what has been described above were tested at electric field values up to 1MV/cm without any alterations being detectable.

The performance of the film is also stable and reproducible over several test cycles.

The impedance curves as a function of frequency for both planar and vertical devices generated with the Keysight B1500A multifrequency module have allowed to estimate also the capacitance values as a function of frequency and to observe that, at a fixed frequency value, εr has very different values in planar and vertical duts (Figure 10). In particular, in vertical devices, εr decreases from 44 at 1 kHz to 39 at about 400 kHz. In planar devices, εr decreases from 1200 at 1kHZ to 1024 at 1MHz.

### Example 2

### BNZT-BCNT - Preparation and Characterization

The salts of barium and calcium, barium acetate and calcium acetate monohydrate, are dissolved in 50 ml of butanol in a 1-liter glass flask connected to a rotary evaporator by setting an oil bath temperature of 85°C for about 1h. Then the oil bath temperature is raised to 125°C to completely dehydrate the salts.

At the same time, in a nitrogen atmosphere the titanium butoxide, zirconium butoxide and niobium ethoxide with suitable stoichiometric concentrations are stabilized: in detail, the titanium butoxide is dissolved in 10 ml of acetic acid and stirred and after 15 minutes the zirconium butoxide is also added and after other 10 minutes the niobium ethoxide is also added. About 1 h is awaited for the complete stabilization.

Once the alkoxides have been stabilized, 50 ml of anhydrous butanol and 10 ml of glacial acetic acid are added. This solution is added to the dehydrated salts in the evaporator with 10 ml of anhydrous ethylene glycol, inside the flask to dissolve the dehydrated salts. The volume of any lost solvent is added to achieve the desired molarity. A precursor solution is thus obtained.

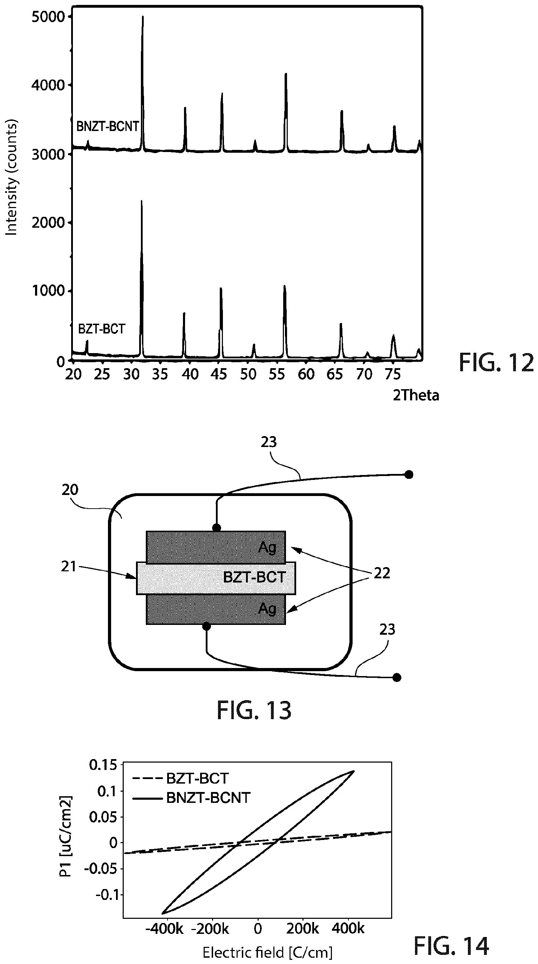

The precursor solution is suitably dried at 120°C in order to obtain an amorphous gel which is calcined in a muffle at 600°C for 5 min to remove the organic fraction. Subsequently, the powder thus obtained is homogenized in a mortar and pressed. The obtained tablet is sintered at 130°C to obtain a dense BNZT-BCNT tablet. The comparison between the diffraction spectra of the BNZT-BCNT and BZT-BCT tablets obtained under the aforesaid conditions is reported in Figure 12.

It may be noted that both samples have a pure perovskite crystalline phase without the presence of secondary phases. This indicates that the Nb⁵⁺ is incorporated in the crystalline phase replacing the Ti⁴⁺ given the similar ionic radius.

In order to measure the properties of the BNZT-BCNT (Nb doped BZT-BCT), a test structure 20 was prepared, shown in Figure 13.

In detail, the test structure 20 has a vertical configuration and comprises a tablet 21 of BNZT-BCNT, that is disc-shaped, prepared as described above, and electrodes 22 of Ag, having circular shape (electrodes in Ag/AgCl solution, annealed at 600°C for 30').

The tablet 21 of BNZT-BCNT was tested by connecting it to a test equipment by two coaxial cables 23; similar measurements were carried out for a BZT-BCT tablet.

Their performances were evaluated by measuring the ferroelectric properties (TFA2000 Aixact), measuring the polarization curve as a function of the electric field, and by measuring the dielectric properties (B1500A Keysight), measuring the capacitance.

The results of the characterizations carried out have been reported in Tables 2 and 3.

**Table 2**

| Tested device | Freq. [kHz] | ΔEc [kV/cm] | ΔPr [uC/cm2] |
|---|---|---|---|
| BZT-BCT tablet | 1 | 510 | 0.0028 |
| BNZT-BCNT tablet | 1 | 1550 | 0.0340 |

The values of ΔPr and ΔEc reported in Table 2 were obtained from the measured experimental ferroelectric curves.

Figure 14 shows the ferroelectric curves measured at the frequency of 1kHz for the two discs described.

As apparent in the comparison between the curves, with the same device, the film containing Nb in the vertical configuration described has better ferroelectric characteristics. Furthermore, by measuring the dielectric constant of both tablets , it was observed that, as expected, the Nb doping also contributes to the improvement of the dielectric properties with the dielectric constant measured at 1 kHz which switches from a value of 507 for the sole BZT-BCT to 1958 for the BNZT-BCNT disc containing the Nb.

**Table 3**

| Tested device | Freq. [kHz] | ε |
|---|---|---|
| BZT-BCT disc | 1 | 507 |
| BNZT-BCNT disc | 1 | 1958 |

Table 3 shows that, with the same configuration, the BNZT-BCNT tablet in the vertical configuration described has an increase in dielectric constant ε due to the denser structure of the Nb-doped tablet.

The addition of Nb as a dopant to the BZT-BCT lead-free material prepared with the described sol-gel method allows to obtain denser and better crystallized thin films, with better stability and better ferroelectric and dielectric performances.

This material may therefore be used in all industrial processes used for the manufacturing of piezoelectric actuation or detection MEMS devices.

## Claims

1. A method for the preparation of a precursor solution for a ceramic of the BZT-αBXT type wherein X is selected from Ca, Sn, Mn and Nb and α is a molar fraction selected in the range between 0.10 and 0.90 comprising the steps of:
a) dissolving at least one barium precursor compound and at least one precursor compound selected from the group consisting of a calcium precursor compound, a tin precursor compound, a manganese precursor compound and a niobium precursor compound in a linear or branched anhydrous alkyl alcohol containing from 2 to 6 carbon atoms and, after dissolution, dehydrating by stripping, to obtain a first solution;
b) dissolving at least one zirconium precursor compound and at least one titanium precursor compound in a linear or branched anhydrous alkyl alcohol containing from 2 to 6 carbon atoms in the presence of an anhydrous chelating agent to obtain a second solution;
c) joining said first and said second solutions in an anhydrous environment and dehydrating by stripping to obtain said precursor solution.

2. The method according to claim 1, wherein said step b) is further carried out in the presence of at least one niobium or tungsten precursor compound.

3. The method according to claim 1, wherein said precursor of calcium, barium, tin, manganese, niobium, zirconium, titanium and tungsten are selected from the group consisting of metal alkoxides, their partial hydrolysates and metal carboxylates, metal-diol complexes, metal-thiol complexes, metal carboxylates, metal-3-diketonate complexes, metal-3-diketoester complexes, metal-3-iminoketo complexes, metal-amine complexes.

4. The method according to any of claims 1 or 3 wherein said barium precursor compound is barium acetate.

5. The method according to any of claims 1 or 3 wherein said calcium precursor compound is calcium acetate.

6. The method according to any of claims 1 to 3 wherein said titanium precursor compound is selected from the group consisting of titanium tetraethoxide, titanium tetraisopropoxide, titanium tetra-n-butoxide, titanium tetraisobutoxide, titanium tetra-t-butoxide, and titanium dimethoxy diisopropoxide.

7. The method according to any of claims 1 to 3 wherein said zirconium precursor compound is selected from the group consisting of zirconium n-propoxide, zirconium tetraethoxide, zirconium tetraisopropoxide, zirconium tetra-n-butoxide, zirconium tetraisobutoxide, zirconium tetra-t-butoxide, and zirconium dimethoxy diisopropoxide.

8. The method according to any of claims 1 to 3 wherein said niobium precursor compound is selected from the group consisting of niobium alkoxides.

9. The method according to any of claims 1 to 3 wherein said tungsten precursor compound is selected from the group consisting of tungsten alkoxides.

10. The method according to claim 1 wherein said chelating agent is selected from the group consisting of glacial acetic acid and anhydrous ethylene glycol.

11. The method according to claim 1 wherein said steps a) and c) are carried out in a rotary evaporator.

12. A precursor solution for a ceramic of the BZT-αBXT type wherein X is selected from Ca, Sn, Mn and Nb and α is a molar fraction selected in the range between 0.10 and 0.90 obtained with the method according to any of claims 1 to 11.

13. A method for the preparation of a film of piezoelectric material made of a ceramic of the BZT-αBXT type wherein X is selected from Ca, Sn, Mn and Nb and α is a molar fraction selected in the range between 0.10 and 0.90 comprising a step of depositing on a substrate a precursor solution according to claim 12, a calcining step and a sintering step.

14. A piezoelectric material made of a ceramic of the BZT-αBXT type wherein X is selected from Ca, Sn, Mn and Nb and α is a molar fraction selected in the range between 0.10 and 0.90 obtained from a precursor solution of claim 12.

15. The piezoelectric material according to claim 14, in the form of a film or powder.

16. An electronic device comprising an active region configured to deform under the action of an external quantity or of a polarization electrical quantity, comprising a layer of piezoelectric material according to claim 14 or 15.
